# EUROPEAN PATENT APPLICATION

(11) **EP 3 716 482 A1**
(43) Date of publication of application: **30.09.2020**
(21) Application number: 18881618.5
(22) Date of filing: 25.10.2018
(51) Int. Cl.: H03K 5/1252, H03H 17/02

(54) **DIGITAL NOISE FILTER**

(30) Priority: 24.11.2017 JP 2017226071
(71) Applicant: Omron Corporation, Kyoto-shi, Kyoto 600-8530 (JP)
(72) Inventor: ASANO, Megumu, Kyoto, 619-0283 (JP); KUBO, Kimikazu, Kyoto, 619-0283 (JP)
(74) Representative: Horn Kleimann Waitzhofer Patentanwälte PartG mbB
(86) International application number: PCT/JP2018/039751
(87) International publication number: WO 2019/102785

(57) **Abstract**

An aspect of the present invention provides a digital noise filter capable of reducing jitter. A digital noise filter (11) which receives, as an input signal, an OFF signal or an ON signal, and removes noise from the input signal, includes: a sampling processing section (11a) configured to carry out sampling of the input signal at a predetermined cycle; and a noise processing section (11b) configured to set the ON signal or the OFF signal as a signal to be outputted, on the basis of a proportion of the ON signal in the sampling which is consecutively carried out a predetermined number of times.

## Description

### Technical Field

The present invention relates to a digital noise filter for removing noise in a signal.

### Background Art

Conventionally, there has been a sensor which outputs two kinds of signals including an ON signal and an OFF signal, depending on whether or not a predetermined event is being detected. An alteration in output of such a sensor may occur due to noise. In order to reduce such an alteration in output, a digital noise filter has been used together. The digital noise filter carries out sampling of a sensor signal, receiving the sensor signal as an input signal. Then, in a case where identical sensor signals are inputted consecutively a predetermined number of times, the digital noise filter outputs that sensor signal as an output signal. In other words, in a case where identical signals are inputted consecutively less than the predetermined number of times, the digital noise filter ignores those signals as noise.

However, in the case of the digital noise filter, in a case where the input signal alters due to noise before identical signals are inputted as input signals consecutively the predetermined number of times, the output signal does not change until identical signals are inputted consecutively the predetermined number of times next. Therefore, the digital noise filter has a larger variation in time which elapses before the output signal changes, that is, a larger jitter in an environment in which the input signal is influenced by noise.

Patent Literature 1 discloses a digital noise filter into which a digital signal is inputted, which digital noise filter includes a counting section as a counting means for counting up or down. The counting section counts up in a case where the input signal is a high signal. In contrast, in a case where the input signal is a low signal, the counting section counts down. In a case where as a result of count by the counting section, a count value reaches a predetermined value, an output signal becomes a high signal. Such a digital noise filter can reduce jitter in an environment in which the input signal is influenced by noise, as compared to the above conventional technique.

### Citation List

### [Patent Literature]

### [Patent Literature 1]

Japanese Patent Application Publication, *Tokukaihei,* No. 10-70444 (Publication date: March 10, 1998)

### Summary of Invention

### Technical Problem

However, even the digital noise filter disclosed in Patent Literature 1 cannot sufficiently reduce jitter.

An aspect of the present invention is to provide a digital noise filter capable of further reducing jitter in an environment in which an input signal is influenced by noise.

### Solution to Problem

In order to solve the above problem, the present invention is configured as follows.

That is, a digital noise filter in accordance with an aspect of the present invention is a digital noise filter receiving, as an input signal, an electric signal corresponding to a digital signal which has either a first signal value or a second signal value, and outputting a signal obtained by removing noise from the input signal, the digital noise filter including: a sampling processing section configured to carry out sampling of the input signal at a predetermined cycle; and a noise processing section configured to (i) set the second signal value as the signal to be outputted, in a case where a proportion of the second signal value is not less than a predetermined proportion in the sampling which is consecutively carried out a predetermined number of times, or (ii) set the first signal value as the signal to be outputted, in a case where the proportion of the second signal value is less than the predetermined proportion in the sampling which is consecutively carried out the predetermined number of times.

### Advantageous Effects of Invention

An aspect of the present invention is to provide a digital noise filter capable of reducing jitter in an environment in which an input signal is influenced by noise.

### Brief Description of Drawings

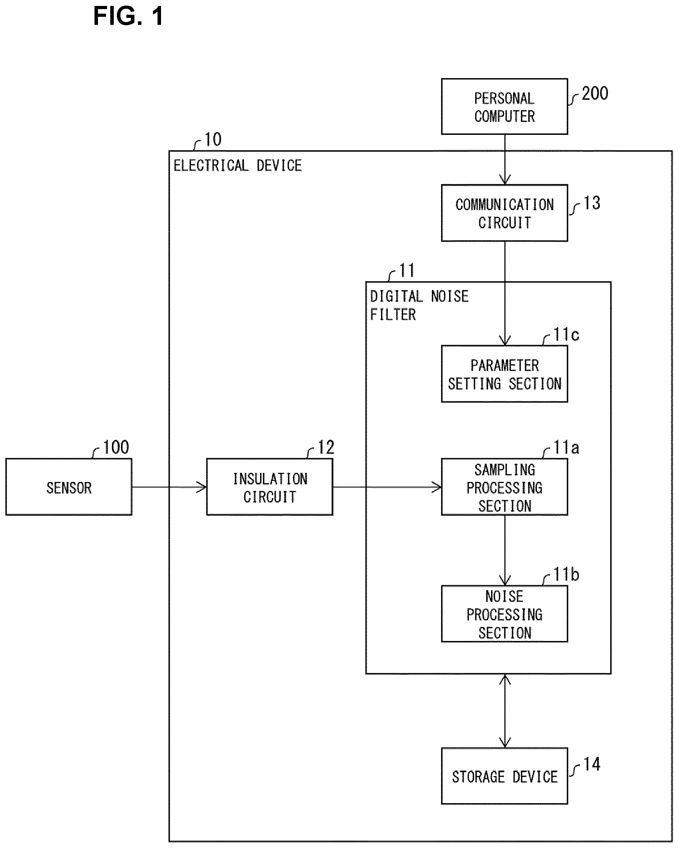

Fig. 1 is a diagram illustrating an example of a case in which a digital noise filter in accordance with an embodiment of the present invention is applied.

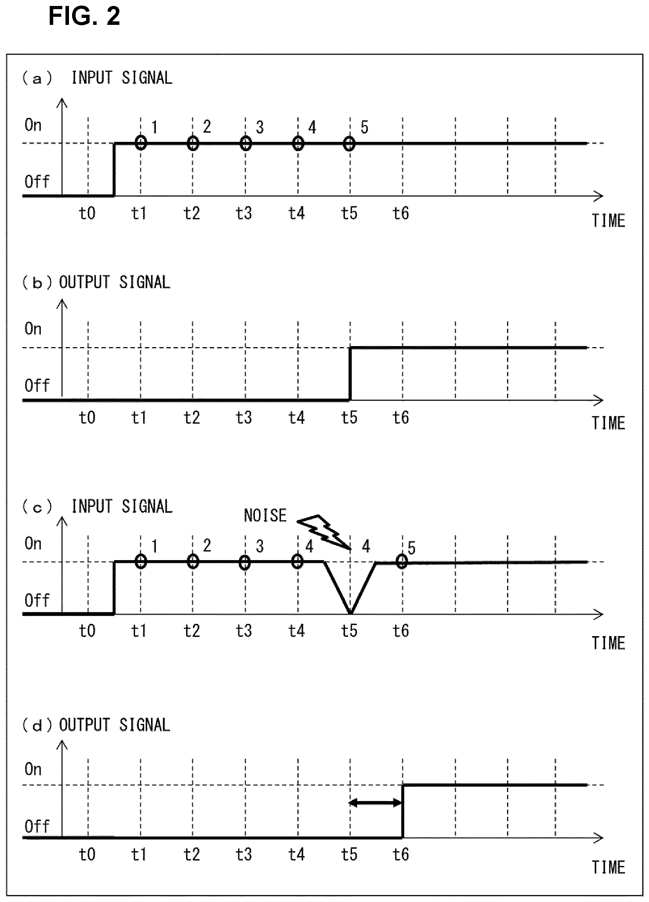

Fig. 2 is a graph with regard to a digital noise filter in accordance with an embodiment of the present invention; and (a) of Fig. 2 is a graph showing an example of an output signal of a sensor which is not influenced by noise, (b) of Fig. 2 is a graph showing an output signal of the digital noise filter which receives, as an input signal, the signal shown in (a) of Fig. 2, (c) of Fig. 2 is a graph showing an example of an output signal of the sensor which is influenced by noise, and (d) of Fig. 2 is a graph showing an output signal of the digital noise filter which receives, as an input signal, the signal shown in (c) of Fig. 2.

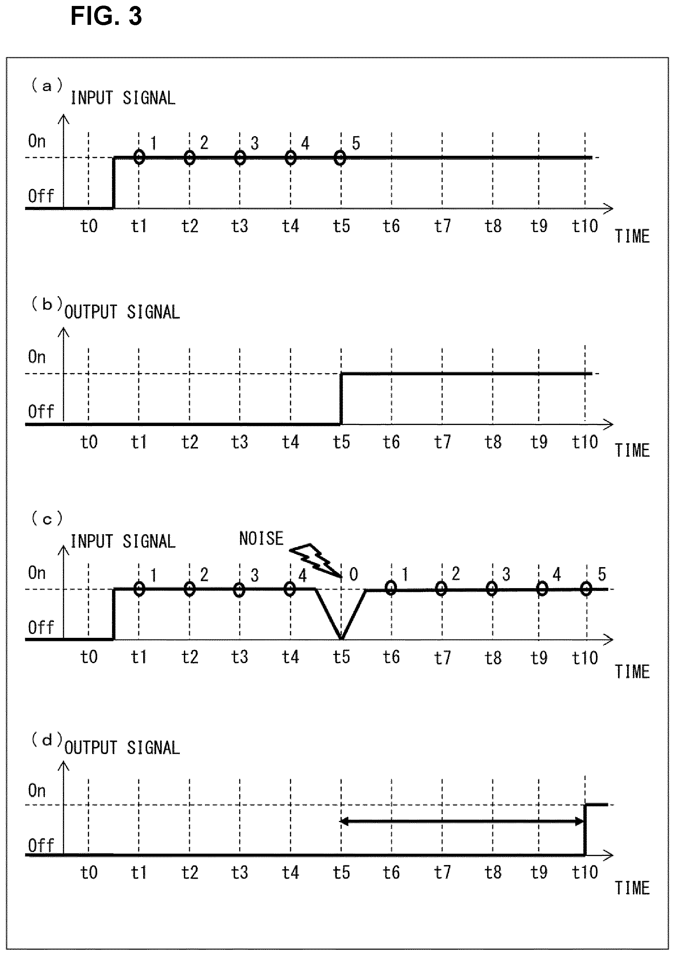

Fig. 3 is a graph with regard to a conventional digital noise filter described earlier in BACKGROUND ART; and (a) of Fig. 3 is a graph showing an example of an output signal of a sensor which is not influenced by noise, (b) of Fig. 3 is a graph showing an output signal of the digital noise filter in accordance with Comparative Example 1, which receives, as an input signal, the signal shown in (a) of Fig. 3, (c) of Fig. 3 is a graph showing an example of an output signal of the sensor which is influenced by noise, and (d) of Fig. 3 is a graph showing an output signal of the digital noise filter in accordance with Comparative Example 1 which receives, as an input signal, the signal shown in (c) of Fig. 3.

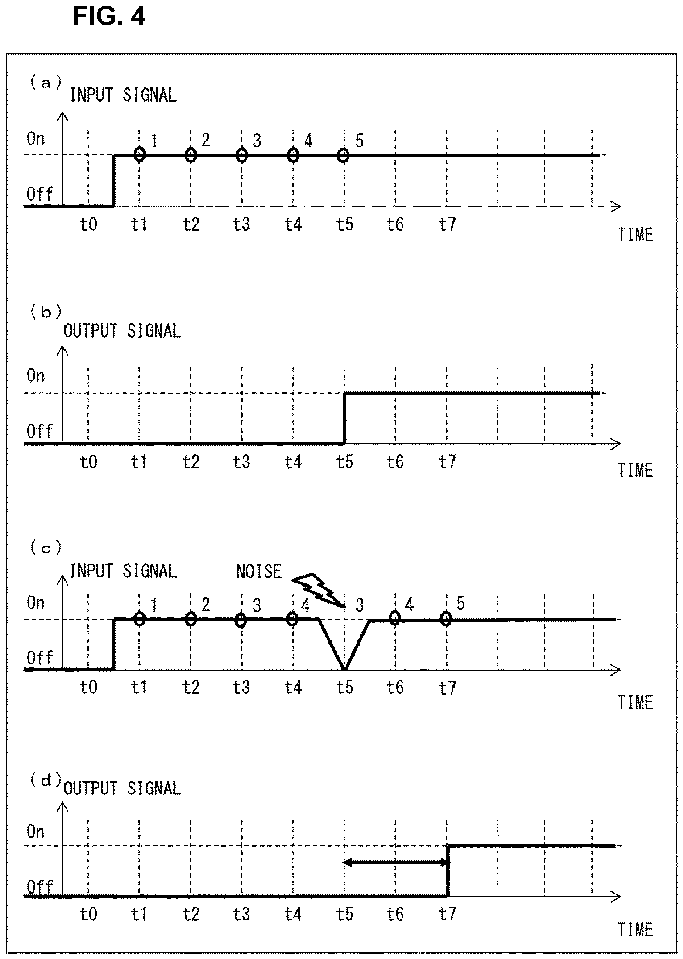

Fig. 4 is a graph with regard to the digital noise filter disclosed in Patent Literature 1; and (a) of Fig. 4 is a graph showing an example of an output signal of a sensor which is not influenced by noise, (b) of Fig. 4 is a graph showing an output signal of the digital noise filter in accordance with Comparative Example 2, which receives, as an input signal, the signal shown in (a) of Fig. 4, (c) of Fig. 4 is a graph showing an example of an output signal of the sensor which is influenced by noise, and (d) of Fig. 4 is a graph showing an output signal of the digital noise filter in accordance with Comparative Example 2, which receives, as an input signal, the signal shown in (c) of Fig. 4.

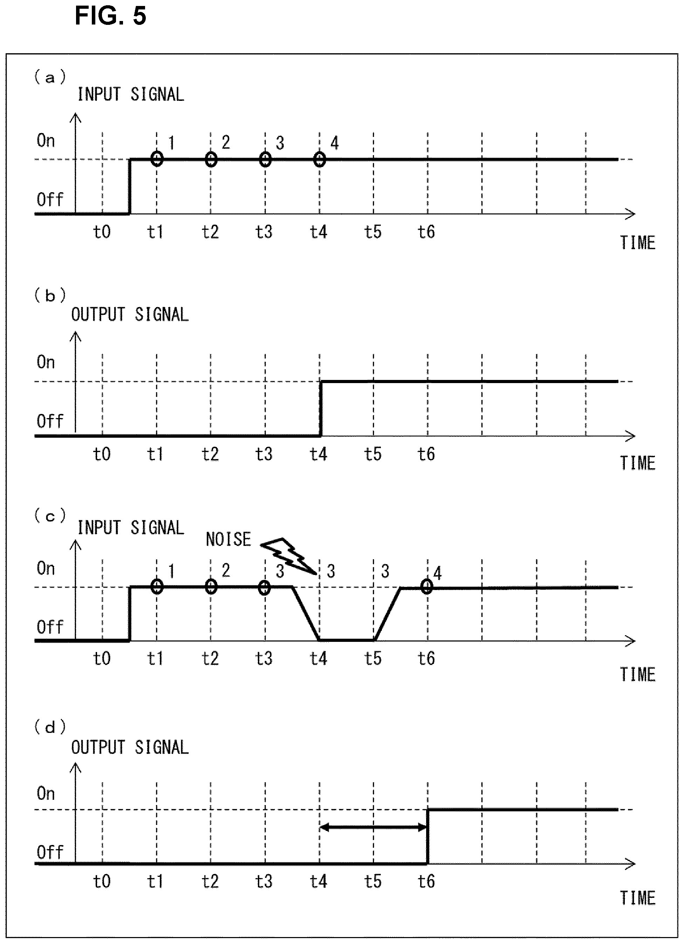

Fig. 5 is a graph with regard to a digital noise filter in accordance with an embodiment of the present invention; and (a) of Fig. 5 is a graph showing an example of an output signal of a sensor which is not influenced by noise, (b) of Fig. 5 is a graph showing an output signal of the digital noise filter which receives, as an input signal, the signal shown in (a) of Fig. 5, (c) of Fig. 5 is a graph showing an example of an output signal of the sensor which is influenced by noise, and (d) of Fig. 5 is a graph showing an output signal of the digital noise filter which receives, as an input signal, the signal shown in (c) of Fig. 5.

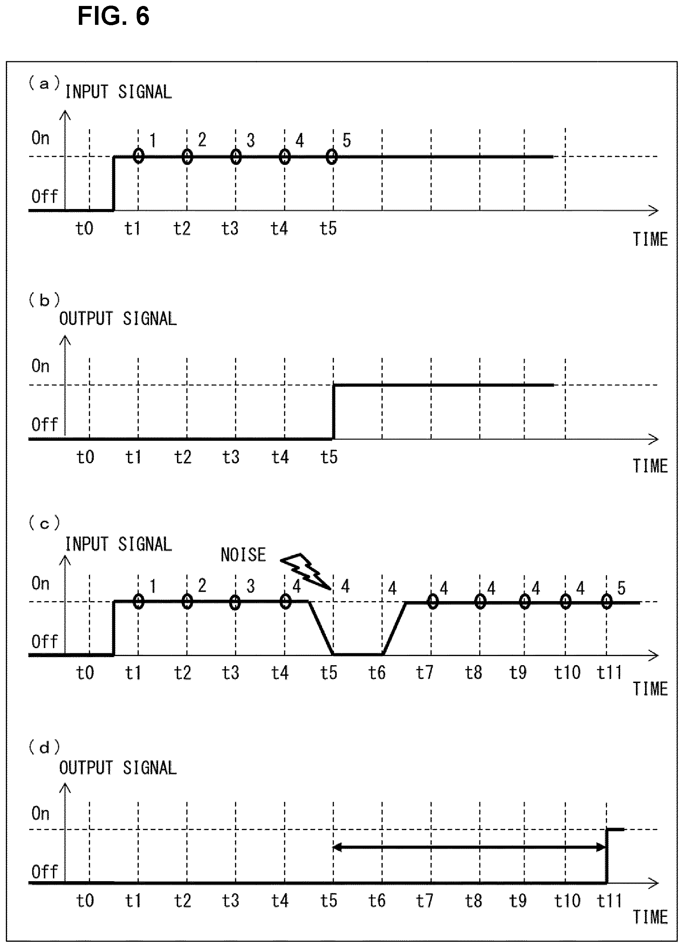

Fig. 6 is a graph with regard to a digital noise filter in accordance with an embodiment of the present invention; and (a) of Fig. 6 is a graph showing an example of an output signal of a sensor which is not influenced by noise, (b) of Fig. 6 is a graph showing an output signal of the digital noise filter in accordance with Comparative Example 3, which receives, as an input signal, the signal shown in (a) of Fig. 6, (c) of Fig. 6 is a graph showing an example of an output signal of the sensor which is influenced by noise, and (d) of Fig. 6 is a graph showing an output signal of the digital noise filter in accordance with Comparative Example 3, which receives, as an input signal, the signal shown in (c) of Fig. 6.

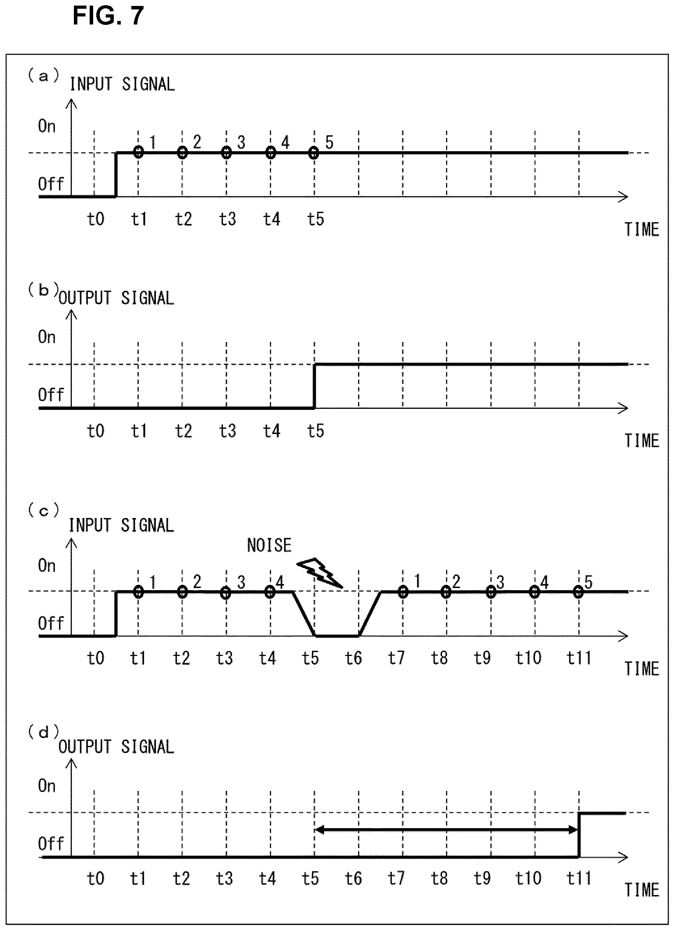

Fig. 7 is a graph with regard to a conventional digital noise filter described earlier in BACKGROUND ART; and (a) of Fig. 7 is a graph showing an example of an output signal of a sensor which is not influenced by noise, (b) of Fig. 7 is a graph showing an output signal of the digital noise filter in accordance with Comparative Example 4, which receives, as an input signal, the signal shown in (a) of Fig. 7, (c) of Fig. 7 is a graph showing an example of an output signal of the sensor which is influenced by noise, and (d) of Fig. 7 is a graph showing an output signal of the digital noise filter in accordance with Comparative Example 4, which receives, as an input signal, the signal shown in (c) of Fig. 7.

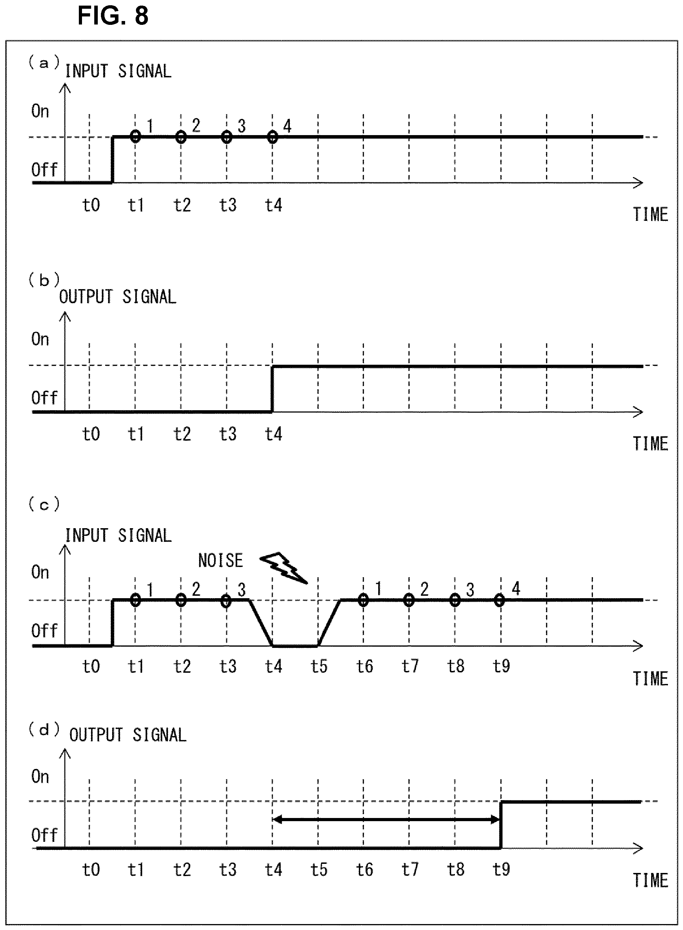

Fig. 8 is a graph with regard to a conventional digital noise filter described earlier in BACKGROUND ART; and (a) of Fig. 8 is a graph showing an example of an output signal of a sensor which is not influenced by noise, (b) of Fig. 8 is a graph showing an output signal of the digital noise filter in accordance with Comparative Example 5, which receives, as an input signal, the signal shown in (a) of Fig. 8, (c) of Fig. 8 is a graph showing an example of an output signal of the sensor which is influenced by noise, and (d) of Fig. 8 is a graph showing an output signal of the digital noise filter in accordance with Comparative Example 5, which receives, as an input signal, the signal shown in (c) of Fig. 8.

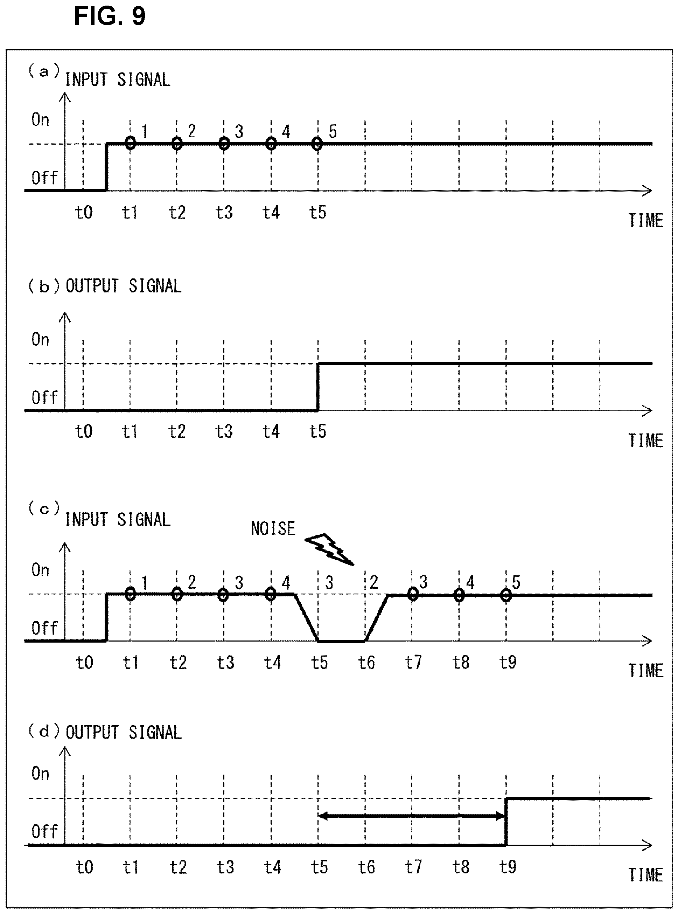

Fig. 9 is a graph with regard to the digital noise filter disclosed in Patent Literature 1; and (a) of Fig. 9 is a graph showing an example of an output signal of a sensor which is not influenced by noise, (b) of Fig. 9 is a graph showing an output signal of the digital noise filter in accordance with Comparative Example 6, which receives, as an input signal, the signal shown in (a) of Fig. 9, (c) of Fig. 9 is a graph showing an example of an output signal of the sensor which is influenced by noise, and (d) of Fig. 9 is a graph showing an output signal of the digital noise filter in accordance with Comparative Example 6, which receives, as an input signal, the signal shown in (c) of Fig. 9.

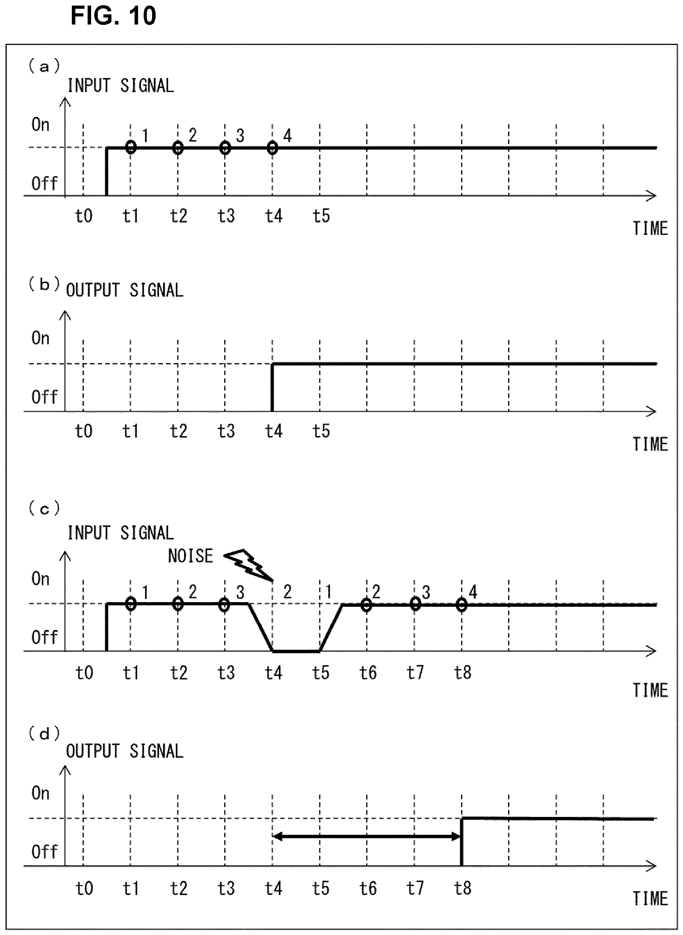

Fig. 10 is a graph with regard to the digital noise filter disclosed in Patent Literature 1; and (a) of Fig. 10 is a graph showing an example of an output signal of a sensor which is not influenced by noise, (b) of Fig. 10 is a graph showing an output signal of the digital noise filter in accordance with Comparative Example 7, which receives, as an input signal, the signal shown in (a) of Fig. 10, (c) of Fig. 10 is a graph showing an example of an output signal of the sensor which is influenced by noise, and (d) of Fig. 10 is a graph showing an output signal of the digital noise filter in accordance with Comparative Example 7, which receives, as an input signal, the signal shown in (c) of Fig. 10.

### Description of Embodiments

The following will discuss an embodiment in accordance with an aspect of the present invention (hereinafter, also referred to as "the present embodiment"), with reference to drawings. However, the present embodiment described below is merely an example of the present invention in every regard. Various modification and alteration can be made within the scope of the claims of the present invention. In other words, it is possible to employ as appropriate a specific configuration in accordance with an embodiment, in implementation of the present invention. Note that data described in the present embodiment is described in natural language, but more specifically, such data is described in/as, for example, any of a quasi-language, commands, parameters, and a machine language which are computer-interpretable.

### §1. Application example

The following description will discuss an example of a case in which an embodiment of the present invention is applied, with reference to Fig. 1. Fig. 1 is a diagram illustrating an example of a case in which a digital noise filter 11 in accordance with the present embodiment is applied. The digital noise filter 11 receives, as an input signal, an electric signal corresponding to a digital signal which is either an OFF signal (first signal value) or an ON signal (second signal value), and outputs, as an output signal, a signal obtained by removing noise from the input signal. In the example illustrated in Fig. 1, the digital noise filter 11 is applied to an electrical device 10. As illustrated in Fig. 1, the electrical device 10 includes a digital noise filter 11, an insulation circuit 12, a communication circuit 13, and a storage device 14. The digital noise filter 11 is connected with a sensor 100 via the insulation circuit 12. Further, the digital noise filter 11 is also connected with a personal computer 200 via the communication circuit 13.

The digital noise filter 11 removes noise from an input signal to the electrical device 10, the input signal is an input from the sensor 100. More specifically, the digital noise filter 11 includes a sampling processing section 11a, a noise processing section 11b, and a parameter setting section 11c.

The sampling processing section 11a carries out sampling of the input signal from the sensor 100, at a predetermined cycle. The predetermined cycle is for example, 250 µs. In a case where in sampling which is consecutively carried out a predetermined number of times by the sampling processing section 11a, a proportion of the ON signal is not less than a predetermined proportion, the noise processing section 11b outputs an ON signal. In a case where in the above sampling, the proportion of the ON signal is less than the predetermined proportion, the noise processing section 11b outputs an OFF signal. In other words, the noise processing section 11b sets the ON signal or the OFF signal as the output signal, depending on whether or not a moving average of the input signal is not less than a certain ratio in sampling which is consecutively carried out a predetermined number of times.

The parameter setting section 11c sets, according to an external input of an instruction, at least one of (i) a predetermined cycle at which the sampling processing section 11a carries out sampling, (ii) a predetermined number of times the sampling is carried out for determination of an output by the noise processing section 11b, and (iii) a predetermined proportion of the ON signal for determination of an output by the noise processing section 11b. The storage device 14 stores a parameter(s) which is/are set by the parameter setting section 11c. Then, the sampling processing section 11a and the noise processing section 11b refers to the parameter(s). Further, in a case where at least one of the above parameters is set so as to be a fixed value which cannot be set by a user, the fixed value is stored in the storage device 14 and referred to by the sampling processing section 11a and the noise processing section 11b.

For example, in a case where the predetermined number of times the sampling is carried out for determination of the output by the noise processing section 11b is increased, the risk of outputting a wrong output signal due to noise can be advantageously reduced. The above increase in the predetermined number of times the sampling is carried out, however, disadvantageously increases an average time which elapses before an ON signal is outputted. This is because in this case, an increased number of ON signals becomes necessary before an ON signal is outputted. In a case where the number of times the sampling is carried out is decreased, the above advantage and disadvantage are reversed.

Further, when the predetermined proportion of the ON signal for determination of an output by the noise processing section 11b is increased, it is possible to advantageously reduce the risk of erroneously outputting an ON signal due to noise in a case where an ON signal is inputted due to noise. On the other hand, there occurs a disadvantage that an ON signal may not be outputted in a case where a wider OFF signal is inputted due to noise. In a case where the predetermined proportion of the ON signal is decreased, the above advantage and disadvantage are reversed.

The insulation circuit 12 is a circuit which is intended to insulate the digital noise filter 11 and the sensor 100 from each other and to allow for input of an output signal of the sensor 100 into the digital noise filter 11. The sensor 100 outputs (i) an OFF signal in a state in which a predetermined event is not being detected or (ii) an ON signal in a state in which the predetermined event is being detected.

The communication circuit 13 is a circuit for communicably connecting the digital noise filter 11 and the personal computer 200 with each other. In the example illustrated in Fig. 1, the communication circuit 13 is connects, by wiring, the digital noise filter 11 and the personal computer 200 with each other. Alternatively, the communication circuit 13 can wirelessly connect the digital noise filter 11 and the personal computer 200 with each other. The personal computer 200 is used for allowing a user to externally input, to the parameter setting section 11c, an instruction regarding a parameter.

The storage device 14 is a storage medium in which information necessary for an operation of the digital noise filter 11 is stored. For example, in the storage device 14, a value(s) which is/are set as above by the parameter setting section 11c is/are stored.

### §2. Configuration example

Next, the following will discuss a hardware configuration example of the electrical device 10.

The electrical device 10 can be, for example, an inverter, a servo or a programmable logic controller (PLC) input unit. In this case, the sensor 100 can be, for example, a photoelectric sensor. In other words, the sensor 100 includes a light source and a photodiode, and outputs (i) an OFF signal in a state in which no incidence of light from a light source is being detected by the photodiode or (ii) an ON signal in a state in which the incidence of light is being detected.

The digital noise filter 11 can be realized by, for example, a micro processing unit (MPU). In other words, the digital noise filter 11 can configured as a microcomputer. Meanwhile, the insulation circuit 12 can be, for example, a circuit in which a photo coupler is incorporated. The communication circuit 13 can be, for example, a circuit which connects the digital noise filter 11 and the personal computer 200 with each other via a communication network. Further, the storage device 14 can be, for example, an electrically erasable programmable read only memory (EEPROM) (registered trademark). Further, the personal computer 200 can be a general-purpose personal computer incorporating a program as a tool for changing the value(s) which is/are set as described above.

### §3. Operation Example 1

The following will discuss respective operation examples of the digital noise filter 11 and of digital noise filters of Comparative Example 1 and Comparative Example 2. All of the digital noise filters described in Operation Example 1 are capable of removing noise having a width up to 1 ms. Further, all of the digital noise filters described in Operation Example 1 each have a sampling cycle of 250 µs.

### (Present embodiment)

The following will discuss an operation example of the digital noise filter 11. In Operation Example 1, the digital noise filter 11 outputs an ON signal in a case where with respect to input signals from the sensor 100, a proportion of ON signals is not less than 80% under the condition that the number of times sampling for noise removal is carried out is 6. In other words, the digital noise filter 11 outputs an ON signal in a case where an ON signal is received not less than 5 times out of 6 consecutive times of sampling of the input signal.

Fig. 2 is a graph with regard to the digital noise filter 11. (a) of Fig. 2 is a graph showing an example of an output signal of the sensor 100 which is not influenced by noise. (b) of Fig. 2 is a graph showing an output signal of the digital noise filter 11 which receives, as an input signal, the signal shown in (a) of Fig. 2. (c) of Fig. 2 is a graph showing an example of an output signal of the sensor 100 which is influenced by noise. (d) of Fig. 2 is a graph showing an output signal of the digital noise filter 11 which receives, as an input signal, the signal shown in (c) of Fig. 2.

In (a) to (d) of Fig. 2, a horizontal axis represents time. Further, each expression tn (where n is an integer) is indicative of time at which sampling is carried out. As described above, since the sampling cycle is 250 µs, each interval between adjacent times tn is 250 µs. Note that in (a) to (d) of Fig. 2, a vertical axis represents a signal which may be ON or OFF. More specifically, the vertical axis represents (i) an output signal of the sensor 100, that is, an input signal to the digital noise filter 11, in (a) and (c) of Fig. 2, and (ii) an output signal of the digital noise filter 11 in (b) and (d) of Fig. 2. Further, (a) and (c) of Fig. 2 each show, by a numeral on the graph, the number of ON signals outputted by the sensor 100 up to the present time (the present time inclusive) at each sampling time in 6 times of sampling.

First, the following will discuss an example shown in (a) and (b) of Fig. 2. In the example shown in (a) of Fig. 2, the output signal of the sensor 100 is an OFF signal at time t0. It is assumed that the output signal of the sensor 100 is an OFF signal also in sampling prior to time t0 (not shown). The output signal of the sensor 100 changes to an ON signal between time t0 and time t1 and thereafter, ON signals are consecutively outputted until time t6.

In this case, at each time from time t0 to time t4, the number of ON signals is not more than 4 in 6 times of sampling up to the present time (the present time inclusive). In other words, the proportion of the ON signals is less than 80% with respect to input signals. Therefore, as shown in (b) of Fig. 2, the output signal of the digital noise filter 11 is an OFF signal up to time t4.

On the other hand, at time t5, the number of ON signals is 5 in 6 times of sampling up to time t5 (time t5 inclusive). In other words, the proportion of the ON signals in 6 times of sampling is not less than 80%. Therefore, as shown in (b) of Fig. 2, the output signal of the digital noise filter 11 is an ON signal at time t5. Further, at each of time t6 and subsequent times, the proportion of ON signals stays not less than 80% in 6 times of sampling including sampling at the present time. Therefore, the output signal of the digital noise filter 11 stays an ON signal.

Next, the following will discuss an example shown in (c) and (d) of Fig. 2. In the example shown in (c) of Fig. 2, as with the example shown in (a) of Fig. 2, the output signal of the sensor 100 is an OFF signal in sampling at time t0 and prior to time t0, and then changes to an ON signal between time t0 and time t1. However, in the example shown in (c) of Fig. 2, the output signal of the sensor 100 alters due to influence of noise between time t4 and time t5. Then, in sampling at time t5, the output signal of the sensor 100 is an OFF signal. Thereafter, the output signal of the sensor 100 returns to an ON signal between time t5 and time t6. As a result, in sampling at time t6 and subsequent times, the output signal of the sensor 100 stays an ON signal.

In this case, as with the example shown in (b) of Fig. 2, at each time from time t0 to time t4, the proportion of ON signals is less than 80% in 6 times of sampling up to the present time (the present time inclusive). Therefore, as illustrated in (d) of Fig. 2, the output signal of the digital noise filter 11 is an OFF signal up to time t4.

At time t5, the output signal of the sensor 100 temporarily becomes an OFF signal. Accordingly, also at time t5, the proportion of ON signals is less than 80% in 6 times of sampling up to time t5 (time t5 inclusive). Therefore, as illustrated in (d) of Fig. 2, the output signal of the digital noise filter 11 is an OFF signal also at time t5.

At time t6, the number of ON signals is 5 in 6 times of sampling including sampling at time t6 since the output signal of the sensor 100 has become an ON signal again. As a result, the proportion of ON signals is greater than 80% at time t6. Therefore, as shown in (d) of Fig. 2, the output signal of the digital noise filter 11 becomes an ON signal at time t6. Further, at each of time t7 and subsequent times, the proportion of ON signals stays not less than 80% in 6 times of sampling including sampling at the present time. Therefore, the output signal of the digital noise filter 11 stays an ON signal.

As described above, in the examples illustrated in (a) to (d) of Fig. 2, the output signal of the digital noise filter 11 becomes an ON signal at time t5 in a case where the input signal of the digital noise filter 11 is not influenced by noise. On the other hand, in a case where the input signal of the digital noise filter 11 is influenced by noise at time t5, the output signal of the digital noise filter 11 becomes an ON signal at time t6. Therefore, in the case of the digital noise filter 11, in a case where the influence of noise occurs at time t5, a jitter of one sampling period, that is, 250 µs occurs. This is clear from a comparison between (b) and (d) of Fig. 2.

### (Comparative Example 1)

The following will discuss an operation example of a digital noise filter in accordance with Comparative Example 1, with reference to Fig. 3. The digital noise filter in accordance with Comparative Example 1 is a conventional digital noise filter described earlier in BACKGROUND ART. Specifically, the digital noise filter in accordance with Comparative Example 1 outputs an ON signal in a case where 5 ON signals are consecutively inputted as input signals.

Fig. 3 is a graph with regard to the conventional digital noise filter described earlier in BACKGROUND ART. (a) of Fig. 3 is a graph showing an example of an output signal of the sensor 100 which is not influenced by noise. (b) of Fig. 3 is a graph showing an output signal of the digital noise filter in accordance with Comparative Example 1, which receives, as an input signal, the signal shown in (a) of Fig. 3. (c) of Fig. 3 is a graph showing an example of an output signal of the sensor 100 which is influenced by noise. (d) of Fig. 3 is a graph showing an output signal of the digital noise filter in accordance with Comparative Example 1 which receives, as an input signal, the signal shown in (c) of Fig. 3. In (a) to (d) of Fig. 3, a horizontal axis and a vertical axis respectively represent the same as those in (a) to (d) of Fig. 2. Further, (a) and (c) of Fig. 3 each show, by a numeral on the graph, the number of ON signals consecutively outputted by the sensor 100 up to the present time at each sampling time.

(a) and (b) of Fig. 3 show an example similar to that shown in (a) and (b) of Fig. 2, in which example no noise exists in the output signal of the sensor 100. Therefore, description of the example shown in (a) and (b) of Fig. 3 will be omitted here.

In the example shown in (c) of Fig. 3, the output signal of the sensor 100 is similar to that in (c) of Fig. 2. In other words, the output signal of the sensor 100 is an OFF signal at time t0 and prior to time t0, and then changes to an ON signal between time t0 and time t1. Subsequently, the output signal of the sensor 100 becomes an OFF signal due to influence of noise at time t5, and then becomes an ON signal again at time t6.

In this case, the output of the digital noise filter in accordance with Comparative Example 1 is an OFF signal up to time t5, as with that of the digital noise filter 11. However, since the ON signal of the output of the sensor 100 is interrupted at time t5, the output of the digital noise filter in accordance with Comparative Example 1 stays an OFF signal up to time t9 even when the output of the sensor 100 returns to an ON signal at time t6. At time t10, the output of the digital noise filter in accordance with Comparative Example 1 becomes an ON signal, since 5 consecutively sampled values from time t6 to time t10 correspond to ON signals. Therefore, in the case of the digital noise filter in accordance with Comparative Example 1, in a case where the influence of noise occurs at time t5, a jitter of 5 sampling periods, that is, 1250 µs occurs. This is clear from a comparison between (b) and (d) of Fig. 3.

### (Comparative Example 2)

The following will discuss an operation example of a digital noise filter in accordance with Comparative Example 2, with reference to Fig. 4. The digital noise filter in accordance with Comparative Example 2 is a digital noise filter disclosed in Patent Literature 1. Specifically, the digital noise filter in accordance with Comparative Example 2 (i) increments by 1 the value of a counter which is initially 0, in a case where the input signal is an ON signal or (ii) lowers the value of the counter by 1 in a case where the input signal is an OFF signal. Then, the digital noise filter outputs an ON signal, in a case where the value of the counter becomes 5. Note however that when the value of the counter is 0, the value of the counter stays the same in a case where the input signal is an OFF signal.

Fig. 4 is a graph with regard to the digital noise filter disclosed in Patent Literature 1. (a) of Fig. 4 is a graph showing an example of an output signal of the sensor 100 in a case where no noise exists. (b) of Fig. 4 is a graph showing an output signal of the digital noise filter in accordance with Comparative Example 2, which receives, as an input signal, the signal shown in (a) of Fig. 4. (c) of Fig. 4 is a graph showing an example of an output signal of the sensor 100 which is influenced by noise. (d) of Fig. 4 is a graph showing an output signal of the digital noise filter in accordance with Comparative Example 2, which receives, as an input signal, the signal shown in (c) of Fig. 4. In (a) to (d) of Fig. 4, a horizontal axis and a vertical axis respectively represent the same as those in (a) to (d) of Fig. 2. Further, in (a) and (c) of Fig. 4, the value of the counter at each time is shown by a numeral on the graph.

(a) and (b) of Fig. 4 show an example similar to that shown in (a) and (b) of Fig. 2, in which example no noise exists in the output signal of the sensor 100. Therefore, description of the example shown in (a) and (b) of Fig. 4 will be omitted here.

In the example shown in (c) of Fig. 4, the output signal of the sensor 100 is similar to that in (c) of Fig. 2. In other words, the output signal of the sensor 100 is an OFF signal in sampling at time t0 and prior to time t0, and then changes to an ON signal between time t0 and time t1. Subsequently, the output signal of the sensor 100 becomes an OFF signal due to influence of noise at time t5, and then becomes an ON signal again at time t6.

In this case, the value of the counter is 4 at time t4, and decreases to 3 at time t5. Thereafter, the value of the counter becomes 4 again at time t6, and then becomes 5 at time t7. Accordingly, as illustrated in (d) of Fig. 4, the output signal of the digital noise filter in accordance with Comparative Example 2 is an OFF signal from time t0 to t6, and becomes an ON signal at time t7 and subsequent times. Therefore, in the case of the digital noise filter in accordance with Comparative Example 2, in a case where the influence of noise occurs at time t5, a jitter of 2 sampling periods, that is, 500 µs occurs. This is clear from a comparison between (b) and (d) of Fig. 4.

§4. Operation Example 2

The following will discuss other operation examples of the digital noise filter 11 in accordance with the present embodiment and of digital noise filters of respective comparative examples.

### (Comparative Example 3)

First, the following will discuss an operation example of the digital noise filter in accordance with Comparative Example 3, with reference to Fig. 6. The digital noise filter in accordance with Comparative Example 3 is configured in the same manner as the digital noise filter 11 in accordance with the present embodiment. However, the input signal to the digital noise filter differs from that in the above-described Operation Example 1.

Fig. 6 is a graph with regard to the digital noise filter 11 as Comparative Example 3. (a) of Fig. 6 is a graph showing an example of an output signal of the sensor 100 which is not influenced by noise. (b) of Fig. 6 is a graph showing an output signal of the digital noise filter in accordance with Comparative Example 3, which receives, as an input signal, the signal shown in (a) of Fig. 6. (c) of Fig. 6 is a graph showing an example of an output signal of the sensor 100 which is influenced by noise. (d) of Fig. 6 is a graph showing an output signal of the digital noise filter in accordance with Comparative Example 3, which receives, as an input signal, the signal shown in (c) of Fig. 6. In (a) to (d) of Fig. 6, a horizontal axis and a vertical axis respectively represent the same as those in (a) to (d) of Fig. 2. Further, (a) and (c) of Fig. 6 each show, by a numeral on the graph, the number of ON signals outputted by the sensor 100 up to the present time (the present time inclusive) at each sampling time in 6 times of sampling.

(a) and (b) of Fig. 6 show an example similar to that shown in (a) and (b) of Fig. 2, in which example no noise exists in the output signal of the sensor 100. Therefore, description of the example shown in (a) and (b) of Fig. 6 will be omitted here.

Also in the example shown in (c) of Fig. 6, the output signal of the sensor 100 is an OFF signal in sampling at time t0 and prior to time t0, and then changes to an ON signal between time t0 and time t1. However, in the example shown in (c) of Fig. 6, the output signal of the sensor 100 alters due to influence of noise between time t4 and time t5. Then, in sampling at time t5 and time t6, a sampled value corresponds to an OFF signal. Thereafter, the output signal of the sensor 100 returns to an ON signal between time t6 and time t7, and stays an ON signal at time t7 and subsequent times.

In this case, at each time from time t0 to time t4, the number of ON signals is less than 5 in 6 times of sampling including sampling at the present time. Further, (i) at each of time t5 and time t6 at which the output signal of the sensor 100 is an OFF signal and (ii) also at each time from time t7 to time t10 after change of the output signal of the sensor 100 back to an ON signal, the number of ON signals is 4 in 6 times of sampling including sampling at the present time. Therefore, from time t0 to time t10, all output signals from the digital noise filter in accordance with Comparative Example 3 are OFF signals.

At time t11, the output of the digital noise filter in accordance with Comparative Example 3 becomes an ON signal since the number of ON signals is 5 in 6 times of sampling including sampling at time t11. Therefore, in the case of the digital noise filter in accordance with Comparative Example 3, in a case where the influence of noise occurs at time t5 and time t6, a jitter of 6 sampling periods, that is, 1500 µs occurs. This is clear from a comparison between (b) and (d) of Fig. 6.

### (Present embodiment)

Next, the following will discuss another operation example of the digital noise filter 11. The digital noise filter 11 in accordance with Operation Example 2 is capable of removing noise having a width of 750 µs at most. In Operation Example 2, the digital noise filter 11 outputs an ON signal in a case where with respect to input signals from the sensor 100, a proportion of ON signals is not less than 60% under the condition that the number of times sampling for noise removal is carried out is 6. In other words, the digital noise filter 11 in accordance with Operation Example 2 outputs an ON signal in a case where an ON signal is received not less than 4 times in 6 consecutive times of sampling of the input signal from the sensor 100.

Fig. 5 is a graph with regard to the digital noise filter 11 in accordance with Operation Example 2. (a) of Fig. 5 is a graph showing an example of an output signal of the sensor 100 which is not influenced by noise. (b) of Fig. 5 is a graph showing an output signal of the digital noise filter 11 which receives, as an input signal, the signal shown in (a) of Fig. 5. (c) of Fig. 5 is a graph showing an example of an output signal of the sensor 100 which is influenced by noise. (d) of Fig. 5 is a graph showing an output signal of the digital noise filter 11 which receives, as an input signal, the signal shown in (c) of Fig. 5. In (a) to (d) of Fig. 5, a horizontal axis and a vertical axis respectively represent the same as those in (a) to (d) of Fig. 2. Further, (a) and (c) of Fig. 5 each show, by a numeral on the graph, the number of ON signals outputted by the sensor 100 up to the present time (the present time inclusive) at each sampling time in 6 times of sampling.

(a) of Fig. 5 show an example of the output signal of the sensor 100, which example is similar to that shown in (a) of Fig. 2. Therefore, description of the example shown in (a) of Fig. 5 will be omitted here. At each time from time t0 to time t3, the number of ON signals is not more than 4 among input signals in 6 times of sampling including sampling at the present time. Accordingly, the proportion of the ON signals is less than 60% with respect to the input signals in the 6 times of sampling. Therefore, as shown in (b) of Fig. 5, the output signal of the digital noise filter 11 is an OFF signal up to time t4.

On the other hand, at time t4, the number of ON signals is 4 among input signals in 6 times of sampling including sampling at time t4. Accordingly, the proportion of the ON signals is not less than 60%with respect to the input signals in the 6 times of sampling. Therefore, as shown in (b) of Fig. 5, the output signal of the digital noise filter 11 becomes an ON signal at time t4. Further, at each time of time t5 and subsequent times, the proportion of ON signals stays not less than 60% with respect to input signals in 6 times of sampling including sampling at the present time. Therefore, at time t5 and subsequent times, the output signal of the digital noise filter 11 also stays an ON signal.

Next, the following will discuss an example shown in (c) and (d) of Fig. 5. In the example shown in (c) of Fig. 5, the output signal of the sensor 100 is an OFF signal at time t0 and prior to time t0, and then changes to an ON signal between time t0 and time t1. Further, in the example shown in (c) of Fig. 5, the output signal of the sensor 100 alters due to influence of noise between time t3 and time t4. Then, at time t4, the output signal of the sensor 100 becomes an OFF signal. Further, in the example shown in (c) of Fig. 5, the output signal of the sensor 100 stays an OFF signal at time t5, and then returns to an ON signal at time t6.

In this case, as with the example shown in (b) of Fig. 5, at each time from time t0 to time t3, the proportion of ON signals is less than 60% with respect to input signals in 6 times of sampling including sampling at the present time. Therefore, as shown in (d) of Fig. 5, the output signal of the digital noise filter 11 is an OFF signal up to time t3.

Further, the output signal of the sensor 100 temporarily becomes an OFF signal at time t4, and stays an OFF signal at time t5. Accordingly, also at each of time t4 and time t5, the proportion of ON signals is less than 60% with respect to input signals in 6 times of sampling including sampling at the present time. Therefore, as illustrated in (d) of Fig. 5, the output signal of the digital noise filter 11 is an OFF signal also at time 4 and time t5.

At time t6, the number of ON signals is 4 in 6 times of sampling including sampling at time t6 since the output signal of the sensor 100 has become an ON signal again. As a result, the proportion of ON signals is greater than 60% at time t6. Therefore, as shown in (d) of Fig. 5, the output signal of the digital noise filter 11 becomes an ON signal at time t6.

In the example described above, the output signal of the digital noise filter 11 becomes an ON signal at time t4 in a case where the input signal of the digital noise filter 11 is not influenced by noise. Meanwhile, the output signal of the digital noise filter 11 becomes an ON signal at time t6 in a case where the input signal of the digital noise filter 11 is influenced by noise at time t4 and time t5. Therefore, in the case of the digital noise filter 11, in a case where the influence of noise occurs at time t4 and time t5, a jitter of 2 sampling periods, that is, 500 µs occurs. This is clear from a comparison between (b) and (d) of Fig. 5.

As described above, the digital noise filter 11 can minimize jitter associated with any input signal by appropriately setting, depending on a length for which the output signal of the sensor 100 is influenced by noise, (i) the number of times sampling is carried out and (ii) the proportion of the number of ON signals with respect to the number of times the sampling is carried out.

### (Comparative Example 4)

The following will discuss an operation example of a digital noise filter in accordance with Comparative Example 4, with reference to Fig. 7. The digital noise filter in accordance with Comparative Example 4, like the digital noise filter in accordance with Comparative Example 1, is a conventional digital noise filter described earlier in BACKGROUND ART. Specifically, the digital noise filter in accordance with Comparative Example 4 outputs an ON signal in a case where 5 ON signals are consecutively inputted as input signals.

Fig. 7 is a graph with regard to the conventional digital noise filter described earlier in BACKGROUND ART. (a) of Fig. 7 is a graph showing an example of an output signal of the sensor 100 which is not influenced by noise. (b) of Fig. 7 is a graph showing an output signal of the digital noise filter in accordance with Comparative Example 4, which receives, as an input signal, the signal shown in (a) of Fig. 7. (c) of Fig. 7 is a graph showing an example of an output signal of the sensor 100 which is influenced by noise. (d) of Fig. 7 is a graph showing an output signal of the digital noise filter in accordance with Comparative Example 4, which receives, as an input signal, the signal shown in (c) of Fig. 7. In (a) to (d) of Fig. 7, a horizontal axis and a vertical axis respectively represent the same as those in (a) to (d) of Fig. 2. Further, (a) and (c) of Fig. 7 each show, by a numeral on the graph, the number of ON signals consecutively outputted by the sensor 100 up to the present time at each sampling time.

(a) and (b) of Fig. 7 show an example similar to that shown in (a) and (b) of Fig. 2, in which example no noise exists in the output signal of the sensor 100. Therefore, description of the example shown in (a) and (b) of Fig. 7 will be omitted here.

In the example shown in (c) of Fig. 7, the output signal of the sensor 100 is similar to that in (c) of Fig. 6. In other words, the output signal of the sensor 100 is an OFF signal in sampling at time t0 and prior to time t0, and then becomes an ON signal between time t0 and time t1. Subsequently, the output signal of the sensor 100 becomes an OFF signal due to influence of noise at time t5. Further, the output signal of the sensor 100 stays an OFF signal in sampling at time t6, and then becomes an ON signal again at time t7.

In this case, the output of the digital noise filter in accordance with Comparative Example 4 is an OFF signal up to time t4, as with the digital noise filter 11. However, since the ON signal of the output of the sensor 100 is interrupted at time t5 and time t6, the output of the digital noise filter in accordance with Comparative Example 4 stays an OFF signal up to time t10 even when the output of the sensor 100 returns to an ON signal at time t7. At time t11, the output of the digital noise filter in accordance with Comparative Example 4 becomes an ON signal, since 5 consecutively sampled values from time t7 to time t11 correspond to ON signals. Therefore, in the case of the digital noise filter in accordance with Comparative Example 4, in a case where the influence of noise occurs at time t5 and time t6, a jitter of 6 sampling periods, that is, 1500 µs occurs. This is clear from a comparison between (b) and (d) of Fig. 7.

### (Comparative Example 5)

The following will discuss an operation example of a digital noise filter in accordance with Comparative Example 5, with reference to Fig. 8. The digital noise filter in accordance with Comparative Example 5, like the digital noise filter in accordance with Comparative Example 4, is a conventional digital noise filter described earlier in BACKGROUND ART. Note, however, that the digital noise filter in accordance with Comparative Example 5 outputs an ON signal in a case where 4 ON signals are consecutively inputted as input signals.

Fig. 8 is a graph with regard to the conventional digital noise filter described earlier in BACKGROUND ART. (a) of Fig. 8 is a graph showing an example of an output signal of the sensor 100 which is not influenced by noise. (b) of Fig. 8 is a graph showing an output signal of the digital noise filter in accordance with Comparative Example 5, which receives, as an input signal, the signal shown in (a) of Fig. 8. (c) of Fig. 8 is a graph showing an example of an output signal of the sensor 100 which is influenced by noise. (d) of Fig. 8 is a graph showing an output signal of the digital noise filter in accordance with Comparative Example 5, which receives, as an input signal, the signal shown in (c) of Fig. 8. In (a) to (d) of Fig. 8, a horizontal axis and a vertical axis respectively represent the same as those in (a) to (d) of Fig. 2. Further, (a) and (c) of Fig. 8 each show, by a numeral on the graph, the number of ON signals consecutively outputted by the sensor 100 up to the present time at each sampling time.

(a) and (b) of Fig. 8 show an example similar to that shown in (a) and (b) of Fig. 5, in which example no noise exists in the output signal of the sensor 100. Therefore, description of the example shown in (a) and (b) of Fig. 8 will be omitted here.

In the example shown in (c) of Fig. 8, the output signal of the sensor 100 is similar to that in (c) of Fig. 5. In other words, the output signal of the sensor 100 is an OFF signal in sampling at time t0 and prior to time t0, and then becomes an ON signal between time t0 and time t1. Subsequently, the output signal of the sensor 100 becomes an OFF signal due to influence of noise at time t4. Further, the output signal of the sensor 100 stays an OFF signal in sampling at time t5, and then becomes an ON signal again at time t6.

In this case, the output of the digital noise filter in accordance with Comparative Example 5 is an OFF signal up to time t3, as with the digital noise filter 11. However, since the ON signal of the output of the sensor 100 is interrupted at time t4 and time t5, the output of the digital noise filter in accordance with Comparative Example 5 stays an OFF signal up to time t8 even when the output of the sensor 100 returns to an ON signal at time t6. At time t9, the output of the digital noise filter in accordance with Comparative Example 5 becomes an ON signal, since 4 consecutively sampled values from time t6 to time t9 correspond to ON signals. Therefore, in the case of the digital noise filter in accordance with Comparative Example 5, in a case where the influence of noise occurs at time t4 and time t5, a jitter of 5 sampling periods, that is, 1250 µs occurs. This is clear from a comparison between (b) and (d) of Fig. 8.

### (Comparative Example 6)

The following will discuss an operation example of a digital noise filter in accordance with Comparative Example 6, with reference to Fig. 9. The digital noise filter in accordance with Comparative Example 6 is a digital noise filter disclosed in Patent Literature 1 as with Comparative Example 2. Specifically, the digital noise filter in accordance with Comparative Example 6 (i) increments by 1 the value of a counter which is initially 0 in a case where the input signal is an ON signal or (ii) lowers the value of the counter by 1 in a case where the input signal is an OFF signal. Then, the digital noise filter outputs an ON signal, in a case where the value of the counter becomes 5. Note however that when the value of the counter is 0, the value of the counter stays the same in a case where the input signal is an OFF signal.

Fig. 9 is a graph with regard to the digital noise filter disclosed in Patent Literature 1. (a) of Fig. 9 is a graph showing an example of an output signal of the sensor 100 which is not influenced by noise. (b) of Fig. 9 is a graph showing an output signal of the digital noise filter in accordance with Comparative Example 6, which receives, as an input signal, the signal shown in (a) of Fig. 9. (c) of Fig. 9 is a graph showing an example of an output signal of the sensor 100 which is influenced by noise. (d) of Fig. 9 is a graph showing an output signal of the digital noise filter in accordance with Comparative Example 6, which receives, as an input signal, the signal shown in (c) of Fig. 9. In (a) to (d) of Fig. 9, a horizontal axis and a vertical axis respectively represent the same as those in (a) to (d) of Fig. 2. Further, in (a) and (c) of Fig. 9, the value of the counter at each time is shown by a numeral on the graph.

(a) and (b) of Fig. 9 show an example similar to that shown in (a) and (b) of Fig. 2, in which example no noise exists in the output signal of the sensor 100. Therefore, description of the example shown in (a) and (b) of Fig. 9 will be omitted here.

In the example shown in (c) of Fig. 9, the output signal of the sensor 100 is similar to that in (c) of Fig. 6. In other words, the output signal of the sensor 100 is an OFF signal in sampling at time t0 and prior to time t0, and then becomes an ON signal between time t0 and time t1. Subsequently, the output signal of the sensor 100 becomes an OFF signal due to influence of noise at time t5. Further, the output signal of the sensor 100 stays an OFF signal in sampling at time t6, and then becomes an ON signal again at time t7.

In this case, the output of the digital noise filter in accordance with Comparative Example 6 is an OFF signal up to time t4, as with the digital noise filter 11. The value of the counter here increases to 4 at time t4. However, since the output of the sensor 100 is an OFF signal at each of time t5 and time t6, the value of the counter decreases to 3 at time t5 and further decreases to 2 at time t6. Thereafter, the output of the sensor 100 returns to an ON signal at time t7. Then, the value of the counter starts to increase again. At time t9, the output of the digital noise filter in accordance with Comparative Example 6 becomes an ON signal since the value of the counter becomes 5. Therefore, in the case of the digital noise filter in accordance with Comparative Example 4, in a case where the influence of noise occurs at time t5 and time t6, a jitter of 4 sampling periods, that is, 1000 µs occurs. This is clear from a comparison between (b) and (d) of Fig. 9.

### (Comparative Example 7)

The following will discuss an operation example of a digital noise filter in accordance with Comparative Example 7, with reference to Fig. 10. The digital noise filter in accordance with Comparative Example 7 is a digital noise filter disclosed in Patent Literature 1, as with Comparative Example 2. Note, however, that the digital noise filter in accordance with Comparative Example 7 outputs an ON signal in a case where the value of the counter becomes 4.

Fig. 10 is a graph with regard to the digital noise filter disclosed in Patent Literature 1. (a) of Fig. 10 is a graph showing an example of an output signal of the sensor 100 which is not influenced by noise. (b) of Fig. 10 is a graph showing an output signal of the digital noise filter in accordance with Comparative Example 7, which receives, as an input signal, the signal shown in (a) of Fig. 10. (c) of Fig. 10 is a graph showing an example of an output signal of the sensor 100 which is influenced by noise. (d) of Fig. 10 is a graph showing an output signal of the digital noise filter in accordance with Comparative Example 7, which receives, as an input signal, the signal shown in (c) of Fig. 10. In (a) to (d) of Fig. 10, a horizontal axis and a vertical axis respectively represent the same as those in (a) to (d) of Fig. 2. Further, in (a) and (c) of Fig. 10, the value of the counter at each time is shown by a numeral on the graph.

(a) and (b) of Fig. 10 show an example similar to that shown in (a) and (b) of Fig. 5, in which example no noise exists in the output signal of the sensor 100. Therefore, description of the example shown in (a) and (b) of Fig. 10 will be omitted here.

In the example shown in (c) of Fig. 10, the output signal of the sensor 100 is similar to that in (c) of Fig. 5. In other words, the output signal of the sensor 100 is an OFF signal in sampling at time t0 and prior to time t0, and then becomes an ON signal between time t0 and time t1. Subsequently, the output signal of the sensor 100 becomes an OFF signal due to influence of noise at time t4. Further, the output signal of the sensor 100 stays an OFF signal in sampling at time t5, and then becomes an ON signal again at time t6.

In this case, the output of the digital noise filter in accordance with Comparative Example 7 is an OFF signal up to time t3, as with the digital noise filter 11. The value of the counter here increases to 3 at time t3. However, since the output of the sensor 100 is an OFF signal at each of time t4 and time t5, the value of the counter decreases to 2 at time t4 and further decreases to 1 at time t5. Thereafter, the output of the sensor 100 returns to an ON signal at time t6. Then, the value of the counter starts to increase again. At time t8, the output of the digital noise filter in accordance with Comparative Example 7 becomes an ON signal since the value of the counter becomes 4. Therefore, in the case of the digital noise filter in accordance with Comparative Example 7, in a case where the influence of noise occurs at time t4 and time t5, a jitter of 4 sampling periods, that is, 1000 µs occurs. This is clear from a comparison between (b) and (d) of Fig. 10.

The digital noise filters in accordance with Comparative Examples 4 to 7 are each a conventional technique or a digital noise filter disclosed in Patent Literature 1. The digital noise filter 11 in accordance with the present embodiment can reduce, by appropriately setting parameters, the level of jitter as shown in Fig. 5, as compared to the digital noise filters in accordance with Comparative Examples 4 to 7.

### (Advantageous effects)

As in the operation examples described above, in the digital noise filter 11 in accordance with the present embodiment, the value of a maximum level of jitter is equal to a period for which a sampled value of the input signal becomes an OFF signal due to noise, in a case where values, such as (i) the number of times sampling is carried out and (ii) the proportion of the number of ON signals, are appropriately set. In contrast, in the digital noise filter in accordance with Comparative Example 1, the value of the maximum level of jitter is equal to the sum of (i) a period for which a sampled value corresponds to an OFF signal due to noise and (ii) the number of ON signals consecutively inputted as input signals before output of an ON signal, which number is set for that digital noise filter. Further, in the digital noise filter in accordance with Comparative Example 2, the value of the maximum level of jitter is equal to twice a period for which a sampled value corresponds to an OFF signal due to noise.

Therefore, the digital noise filter 11 in accordance with the present embodiment can reduce jitter as compared to the digital noise filters in accordance with Comparative Examples 1 and 2.

Note that the values set as described above can be adjusted by a user as appropriate so that noise of a signal which is actually outputted will be minimized. Specifically, for example, the values set as described above can be appropriately adjusted on the basis of an error and jitter in a test operation in which, for example, the above-described values are set to convenient initial values, by carrying out the test operation.

Further, in the embodiment described above, the digital noise filter 11 receives, as an input signal, an output signal of a sensor 100 which is configured to output: (i) the first signal value in a state in which a predetermined event is not being detected; or (ii) the second signal value in a state in which a predetermined event is being detected. Accordingly, the digital noise filter 11 can reduce influence of noise on the second signal value which is outputted in a case where the sensor 100 detects a predetermined event.

Note that the above-described operation examples each have dealt with a case where the output of a digital noise filter in accordance with each of Operation Examples and Comparative Examples switches from an OFF signal to an ON signal. In contrast to the case described above, in a case where the output of the digital noise filter 11 in accordance with the present embodiment switches from an ON signal to an OFF signal, the output is switched in a case where the proportion of OFF signals inputted is not less than a predetermined proportion with respect to input signals in sampling which is carried out a predetermined number of times.

### §5. Variations

The digital noise filter 11 of an electrical device 10 can be realized by an MPU, that is, software as described above or can be alternatively realized by hardware.

Further, the communication circuit 13 can be, for example, a circuit which connects the digital noise filter 11 and the personal computer 200 with each other via a universal serial bus (USB). Further, the storage device 14 can be, for example, a solid state drive (SSD), or a flash memory. Further, it is possible to provide no storage device 14 in the digital noise filter 11, and connect the digital noise filter 11 with an external storage device.

Furthermore, as described above, it is possible to change, according to an input of a user, (i) the number of times sampling is carried out, which sampling is used by the noise processing section 11b for determining an output signal and (ii) the proportion of ON signals with respect to input signals, for causing the output signal to be an ON signal. Therefore, the number of times the sampling is carried out can be set to the number other than 6, and the proportion of the ON signals can be set to a proportion which is neither 80% nor 60%. In addition, the sampling cycle can be set to a length other than 250 µs.

Aspects of the present invention can also be expressed as follows.

In order to solve the above problem, the present invention is configured as follows.

That is, a digital noise filter in accordance with an aspect of the present invention is a digital noise filter receiving, as an input signal, an electric signal corresponding to a digital signal which has either a first signal value or a second signal value, and outputting a signal obtained by removing noise from the input signal, the digital noise filter including: a sampling processing section configured to carry out sampling of the input signal at a predetermined cycle; and a noise processing section configured to (i) set the second signal value as the signal to be outputted, in a case where a proportion of the second signal value is not less than a predetermined proportion in the sampling which is consecutively carried out a predetermined number of times, or (ii) set the first signal value as the signal to be outputted, in a case where the proportion of the second signal value is less than the predetermined proportion in the sampling which is consecutively carried out the predetermined number of times.

In the above configuration, the digital noise filter includes a sampling processing section and a noise processing section. The sampling processing section carries out, at a predetermined cycle, sampling of an input signal which is an electric signal corresponding to a digital signal which has either a first signal value or a second signal value. The noise processing section is configured to (i) set the second signal value as the signal to be outputted, in a case where a proportion of the second signal value is not less than a predetermined proportion in the sampling which is consecutively carried out a predetermined number of times by the sampling processing section, or (ii) set the first signal value as the signal to be outputted, in a case where the proportion of the second signal value is less than the predetermined proportion in the sampling which is consecutively carried out the predetermined number of times by the sampling processing section. The digital noise filter outputs a signal obtained by removing noise from the input signal, by outputting the signal which has been outputted by the noise processing section.

Therefore, in the digital noise filter, an output is determined on the basis of the proportion of the second signal value in the sampling which is consecutively carried out the predetermined number of times. Accordingly, even in a case where the continuity of the second signal value is interrupted due to influence of noise in the sampling which is consecutively carried out the predetermined number of times, it is possible to subsequently determine the output on the basis of signal values including the second signal value prior to that interruption in sampling which is consecutively carried out the predetermined number of times. This shortens a time which elapses before the output turns to the second signal value.

The digital noise filter in accordance with an aspect of the present invention further includes: a parameter setting section configured to set, according to an external input of an instruction, at least one of the predetermined cycle, the predetermined number of times, and the predetermined proportion.

In the above configuration, a user externally inputs an instruction with respect to the parameter setting section, so that the user can set at least one of (i) a cycle of sampling by the sampling processing section, (ii) the number of times the sampling is carried out for determination of the output by the noise processing section, and (iii) a proportion of the second signal value for determination of the output by the noise processing section. This makes it possible to set an appropriate parameter(s), for example, in accordance with assumed noise and/or the like in an input into the digital noise filter.

In the digital noise filter in accordance with an aspect of the present invention, the input signal is an output signal from a sensor which is configured to output (i) the first signal value in a state in which a predetermined event is not being detected; or (ii) the second signal value in a state in which the predetermined event is being detected.

The digital noise filter may receive, as an input signal from the sensor, a signal indicative of a state opposite to an actually detected state of a predetermined event for only a short period of time, due to noise caused by an external disturbance. With the above configuration, the digital noise filter can reduce influence of noise, even in a case where a signal indicative of a state opposite to an actually detected state of a predetermined event is inputted for only a short period of time, due to influence of noise, in sampling which is consecutively carried out a predetermined number of times.

The present invention is not limited to the embodiments, but can be altered by a skilled person in the art within the scope of the claims. The present invention also encompasses, in its technical scope, any embodiment derived by combining technical means disclosed in differing embodiments.

### Reference Signs List

- 11: digital noise filter
- 11a: sampling processing section
- 11b: noise processing section
- 11c: parameter setting section
- 100: sensor

## Claims

1. A digital noise filter receiving, as an input signal, a digital signal which has either a first signal value or a second signal value, and outputting a signal obtained by removing noise from the input signal, the digital noise filter comprising:
a sampling processing section configured to carry out sampling of the input signal at a predetermined cycle; and
a noise processing section configured to (i) set the second signal value as the signal to be outputted, in a case where a proportion of the second signal value is not less than a predetermined proportion in the sampling which is consecutively carried out a predetermined number of times, or (ii) set the first signal value as the signal to be outputted, in a case where the proportion of the second signal value is less than the predetermined proportion in the sampling which is consecutively carried out the predetermined number of times.

2. A digital noise filter as set forth in claim 1, further comprising:
a parameter setting section configured to set, according to an external input of an instruction, at least one of the predetermined cycle, the predetermined number of times, and the predetermined proportion.

3. The digital noise filter as set forth in claim 1 or 2, wherein:
the input signal is an output signal from a sensor which is configured to output (i) the first signal value in a state in which a predetermined event is not being detected; or (ii) the second signal value in a state in which the predetermined event is being detected.
